# DEMANDE DE BREVET EUROPEEN

(11) **EP 4 682 464 A1**
(43) Date de publication de la demande: **21.01.2026**
(21) Numéro de dépôt: 25189124.8
(22) Date de dépôt: 11.07.2025
(51) Int. Cl.: G01B 7/02, G01R 31/11, G01R 31/58, G01R 31/54

(54) **DISPOSITIF POUR DÉTERMINER LA LONGUEUR D'UN CÂBLE ÉLECTRIQUE INERTE, ET PROCÉDÉ DE DÉTECTION DU SECTIONNEMENT D'UN CÂBLE ÉLECTRIQUE INERTE**

(30) Priorité: 15.07.2024 FR 2407709; 31.07.2024 FR 2408472
(71) Demandeur: Société Rhodanienne d'Electronique Appliquée, 69120 Vaulx-en-Velin (FR)
(72) Inventeur: FEDORIW, Robin, 69370 PIERRE BENITE (FR)
(74) Mandataire: IXAS Conseil

(57) **Abrégé**

Dispositif (1,100) pour surveiller pendant une certaine durée de surveillance un câble inerte, notamment pour détecter un événement se produisant au cours de cette durée de surveillance, tel que sa découpe, ledit dispositif étant configuré pour déterminer de manière répétée la valeur d'un paramètre représentatif de la longueur d'une paire de brins sélectionnée au sein dudit câble, et pour détecter un événement de diminution brusque de cette valeur,
ledit dispositif étant caractérisé en ce qu'il comprend une carte mère (20) et une pluralité de cartes fille (30),
chaque carte fille étant configurée pour déterminer sur une paire de brins inerte un paramètre représentatif de la longueur de ladite paire de brins, et pour transmettre ce paramètre ce paramètre à la carte mère,
et la carte mère étant configurée pour comparer, pour chaque carte fille, les paramètres représentatifs de la longueur à une valeur de seuil, et pour déclencher une alerte en cas de franchissement de cette valeur de seuil.

## Description

### Domaine technique de l'invention

L'invention concerne le domaine de l'électrotechnique, et plus particulièrement celui des mesures de paramètres électriques d'un conducteur électrique linéaire de type câble électrique. Plus précisément, l'invention concerne un dispositif pour déterminer la longueur d'un câble électrique inerte, c'est-à-dire d'un câble électrique qui ne fait pas partie d'un circuit électrique sous tension. L'invention s'applique notamment aux câbles composés de paires brins de cuivre torsadées, tels que des câbles de type ADSL (Asymmetric Digital Subscriber Line).

L'invention concerne également l'utilisation d'un tel dispositif pour déterminer la longueur d'un câble électrique inerte d'un type déterminé. L'invention concerne également un procédé pour surveiller l'intégrité d'un câble électrique inerte, et plus particulièrement pour détecter son sectionnement, en utilisant le dispositif selon l'invention. Le sectionnement du câble conduit à la diminution de sa longueur ininterrompue. Ce procédé de détection ou de surveillance peut être mis en œuvre de manière ponctuelle, mais aussi de manière permanente pour détecter en temps réel le vol de câbles électriques inertes, dans de multiples situations.

L'invention concerne également un système radioélectrique de surveillance de câbles inertes qui comporte une pluralité de dispositifs selon l'invention.

### Etat de la technique

Les opérateurs de réseaux électriques sont confrontés au problème de vol de câbles électriques. Ce problème concerne surtout les câbles destinés à des basses tensions ou les câbles déconnectés mais laissés en place, car dans ces cas le voleur qui sectionne et découpe le câble n'est pas sujet à un risque d'électrocution. Par ailleurs, le sectionnement et vol d'un câble qui n'est pas sous tension ne perturbe pas le fonctionnement d'un système technique, et est de ce fait difficile à détecter en temps réel. Ces vols peuvent avoir lieu sur site d'installation ou sur un chantier, et peuvent concerner dans ce cas des câbles déconnectés qui sont restés en place en attente de leur enlèvement, ou des câbles neufs qui sont stockés en attente de leur mise en place. Ils peuvent aussi avoir lieu sur un parc de matériel. Ces vols peuvent être commis par les acteurs d'une filière criminelle organisée qui intègre par expérience souvent les voleurs opérant sur le terrain, les commettants-revendeurs et les recycleurs. Ces vols peuvent aussi être commis par le personnel d'entreprises qui récupèrent les câbles à la demande de leur propriétaire pour les introduire dans la filière de recyclage ; dans ce cas il s'agit le plus souvent d'un vol partiel d'un lot par découpage d'une longueur plus importante que prévue ou signalée (sachant que la longueur totale d'un câble inerte posé n'est pas toujours bien documentée).

Il existe un besoin évident de pouvoir déterminer facilement la longueur d'un câble électrique inerte, connecté ou déconnecté, de préférence sans le dérouler. Il existe également un besoin de pouvoir détecter la coupure d'un câble électrique inerte, connecté ou déconnecté, afin de pouvoir émettre une alerte. Ce moyen de détection doit pouvoir être utilisé de manière simple et fiable, et doit pouvoir être mise en oeuvre sur le terrain (c'est-à-dire sur des câbles installés et sur des câbles stockés dans diverses conditions, notamment à l'extérieur).

La présente invention apporte une solution simple à ces problèmes.

### Objets de l'invention

Selon l'invention, le problème est résolu par un dispositif pour surveiller pendant une certaine durée de surveillance un câble inerte, notamment pour détecter un événement se produisant au cours de cette durée de surveillance, tel que sa découpe, ledit dispositif étant configuré pour déterminer de manière répétée la valeur d'un paramètre représentatif de la longueur d'une paire de brins sélectionnée au sein dudit câble, et pour détecter un événement de diminution brusque de cette valeur,
ledit dispositif étant caractérisé en ce qu'il comprend une carte mère et une pluralité de cartes filles,
chaque carte fille étant configurée pour déterminer sur une paire de brins inerte un paramètre représentatif de la longueur de ladite paire de brins, et pour transmettre ce paramètre ce paramètre à la carte mère,
et la carte mère étant configurée pour comparer, pour chaque carte fille, les paramètres représentatifs de la longueur à une valeur de seuil, et pour déclencher une alerte en cas de franchissement de cette valeur de seuil.

La répartition des fonctions et composants sur une carte mère et une pluralité de cartes filles, par opposition à une disposition mono-carte, présente des avantages qui dépassent la simple modularité du dispositif : le fait d'éviter toute connexion électrique entre la carte mère et les cartes filles garantit en toutes circonstances l'isolation galvanique entre les cartes filles et la carte mère.

Ce dispositif représente le premier objet de la présente invention.

Selon d'autres caractéristiques avantageuses de ce dispositif :
- Ledit paramètre représentatif de la longueur d'une paire de brins est déterminé à partir d'une mesure capacitive, ledit circuit de mesure capacitive se trouvant de préférence sur chaque carte fille.
- Ladite carte mère comprend une unité de relais, permettant d'actionner pour chaque carte fille un relais en cas de franchissement du seuil. Ladite carte fille comprend un microcontrôleur configuré pour acquérir des mesures de durée de cycles charge - décharge de la capacité représentée par la paire de brins de câble, pour stocker ces données, éventuellement pour effectuer un filtrage numérique de ces données, et pour les communiquer à la carte mère.
- Ladite carte mère est configurée pour communiquer avec une machine informatique distante, notamment pour transmettre les mesures acquises par toutes les cartes fille.

Le dispositif selon l'invention peut être réalisé sous la forme d'un boîtier qui comprend une carte mère et une pluralité de cartes filles (par exemple huit), dont chacune détermine la longueur d'une paire de brins. Les mesures effectuées par chaque carte fille sont collectées, filtrées numériquement et gérées par la carte mère, qui assure également la gestion des relais et des alarmes. Les données sont transmises à un serveur de collecte.

Le dispositif selon l'invention permet la surveillance d'un câble inerte sur une durée importante. On constate en effet une très grande stabilité de ces mesures au cours du temps si la longueur du câble ou son environnement capacitif ne changent pas.

Un deuxième objet de la présente invention est un procédé pour surveiller pendant une certaine durée de surveillance un câble inerte, notamment pour détecter un événement se produisant au cours de cette durée de surveillance, tel que sa découpe, ledit procédé comprenant :
- la sélection d'une paire de brins supervisables,
- le branchement de ladite paire de brins sur un dispositif capable déterminer la capacité de ladite paire de brins,
- la mesure répétée au cours de ladite durée de surveillance d'un paramètre représentatif de la longueur de ladite paire de brins issu de la détermination de la capacité de ladite paire de brins,
- la surveillance dudit paramètre représentatif de la longueur par ledit dispositif.

On peut effectuer une calibration dudit paramètre représentatif de la longueur pour exprimer une unité de longueur, ladite calibration étant de préférence établie à l'aide d'un échomètre. Cela se fait lors de la mise en service du dispositif sur un chantier donné et permettant ainsi d'ajuster précisément les mesures effectuées par les cartes fille. Ce processus d'étalonnage garantit la fiabilité des mesures de longueur de câble.

Dans le procédé selon l'invention une alerte peut être déclenchée lorsque ledit paramètre représentatif de la longueur franchit un certain seuil indiquant une coupure dudit câble. Lors de la surveillance du câble selon le procédé selon l'invention, lorsque ledit paramètre représentatif de la longueur change d'une première valeur vers une deuxième valeur et indique qu'une certaine longueur de câble a été découpée, on peut utiliser cette deuxième valeur comme la nouvelle valeur initiale, et on poursuit le procédé pour surveiller ledit câble inerte.

Ladite paire de brins peut faire partie d'un câble de transmission de données installé sur un commutateur, le branchement entre lesdits brins et ledit dispositif se faisant par l'intermédiaire d'une jarretière, dont une extrémité est connectée audit dispositif, directement ou par l'intermédiaire d'une tête de répartiteur.

Encore un autre objet de la présente invention est l'utilisation d'un dispositif selon l'invention pour la surveillance de câbles inertes, lesdites câbles étant des câbles pourvus de paires de brins torsadés, et notamment de câbles de transmission de données, lesdits câbles inertes pouvant notamment être des câbles installés laissés en place en attente de leur démantèlement, ou des câbles en attente sur un lieu d'entreposage, notamment en attente de leur installation ou de leur recyclage.

Encore un autre objet de la présente invention est un réseau radioélectrique pour la surveillance de la longueur d'une pluralité de câbles inertes, comprenant :
- une pluralité de dispositifs selon l'invention,
- une machine informatique centrale configurée pour communiquer de manière bidirectionnelle avec lesdits dispositifs, de préférence par l'intermédiaire de leur carte mère, pour centraliser les mesures reçues par ladite pluralité de dispositifs, pour pourvoir transmettre des données à une machine informatique utilisateur, pour rerouter les alertes générées par un dispositif vers une machine informatique utilisateur et/ou une installation de surveillance utilisateur, et pour pouvoir calibrer et maintenir les dispositifs,
- et au moins une machine informatique utilisateur configurée pour communiquer de manière bidirectionnelle avec ladite machine informatique centrale, pour, en particulier, effectuer la vérification de la cohérence de la mesure de capacité lors de la sélection de la paire de brins, pour entrer la longueur de câble déterminée par la calibration pour entrer la valeur de seuil, et pour exporter de données générées par ledit dispositif et/ou ladite machine informatique centrale.

Dans un mode de réalisation avantageux, ladite machine informatique centrale est configurée pour mettre à la disposition d'un utilisateur, par l'intermédiaire de la machine informatique utilisateur, une interface utilisateur personnelle permettant à l'utilisateur d'effectuer la vérification de la cohérence de la mesure de capacité lors de la sélection de la paire de brins, d'entrer la longueur de câble déterminée par la calibration, d'entrer la valeur de seuil, et/ou d'exporter des données générées par ledit dispositif et/ou ladite machine informatique centrale.

Avantageusement, ladite machine informatique utilisateur est configurée pour que, dans le cas où ledit paramètre représentatif de la longueur change d'une première valeur vers une deuxième valeur et indique qu'une certaine longueur de câble a été découpée, cette deuxième valeur soit utilisée comme la nouvelle valeur initiale, et on poursuit le procédé pour surveiller ledit câble inerte.

### Brève description des figures

[Fig. 1] montre de manière schématique un dispositif selon l'invention et les principaux composants de la carte mère.
[Fig. 2] montre de manière schématique un carte fille du dispositif selon l'invention, avec ses principaux composants.
[Fig. 3] montre de manière schématique un mode de réalisation typique du procédé selon l'invention.
[Fig. 4] montre de manière schématique une partie du procédé selon l'invention qui concerne la sélection d'une paire de brins supervisable.
[Fig. 5] montre de manière schématique une partie du procédé selon l'invention qui concerne l'identification d'un événement.
[Fig. 6] montre de manière schématique une partie du procédé selon l'invention qui concerne l'activation d'un relais suite à la détection d'un événement.
[Fig. 7] montre de manière schématique une partie du procédé selon l'invention qui concerne l'envoi d'une alerte vers un serveur client suite à la détection d'un événement.
[Fig. 8] montre de manière schématique un réseau radioélectrique selon l'invention.
[Fig. 9] se réfère à l'exemple 1 et montre l'évolution de la longueur de huit câbles surveillés par un même dispositif selon l'invention. Il s'agit d'un essai visant à déterminer la stabilité du signal en conditions stationnaires.
[Fig. 10] est une sélection agrandie de la [Fig. 9] et représente le signal pour le câble présentant le signal le moins stable.
[Fig. 11] est une sélection agrandie de la [Fig. 9] et représente le signal pour le câble présentant le signal le plus stable.
[Fig. 12] se réfère à l'exemple 2 et montre l'évolution de la longueur de huit câbles surveillés par un même dispositif selon l'invention. Dans cet essai les câbles ont été coupés à certains endroits.
[Fig. 13] se réfère à la [Fig. 12] dont il montre la câble n° 4 en agrandissement de l'échelle verticale. La courbe (a) montre la longueur du câble telle que déterminée avec le dispositif selon l'invention après calibration, et la courbe (b) montre la longueur du câble déterminée par échométrie.

Les signes de référence suivantes sont utilisés sur les figures et dans la description :
1,100 Dispositif selon l'invention
2 Câbles de raccordement (strap)
10 Boîtier
20 Carte mère
21 Unité d'alimentation
22 Processeur (typiquement ordinateur à carte unique)
23 Bornier d'entrée pour 2
24 Bornier de cartes fille
25 Unité de communication
26 Unité de relais avec un relais (26-1 à 26-8) pour chaque carte fille
30-1 à 30-8 Carte filles
31 Module de connexion, conçu pour coopérer avec 24
32 Dispositif de protection contre la foudre
33 Unité d'alimentation
34 Unité de mesure capacitive
341 Microcontrôleur avec horloge pour 34
35 Microcontrôleur
36 Unité d'interfaçage
200 Machine informatique centrale
300 Machine informatique utilisateur

Les repères numériques à quatre chiffres désignent des étapes de procédé.

### Description de l'invention

### a) Terminologie et généralités

On appelle ici un câble « inerte » un câble électrique dont au moins une paire de brins n'est pas sous tension. Ledit câble électrique peut être un câble destiné au transport d'énergie électrique ou un câble destiné à la transmission de données. Il comprend une pluralité de brins de cuivre recouverts d'isolant.

Le terme « paire de cuivre torsadée » (ou plus simplement « paire torsadée », en anglais « twisted pair ») désigne dans une paire de brins de cuivre recouverts d'isolant et torsadés. Ces brins ont habituellement un diamètre compris entre 0,3 mm et 1,0 mm, les diamètres le plus courants étant 0,4 mm et 0,5 mm, et on connaît aussi des brins de diamètre 0,6 mm et 0,8 mm. Le fait de torsader les brins les rend plus résistants au couplage électromagnétique avec des perturbateurs externes, et diminue la radiation électromagnétique vers l'extérieur qui serait susceptible de perturber des paires proches. Inventée par Graham Bell en 1881 pour la téléphonie, la paire de cuivre torsadée est utilisée aujourd'hui dans des câbles destinés à la transmission de données.

Pour la transmission de données, on distingue les câbles de branchement, qui relient les postes des usagers jusqu'à un point de concentration (PC) et qui comprennent typiquement une dizaine un ou plusieurs dizaines de paires identiques, les câbles de distribution, qui relient les points de concentration aux sous-répartiteurs (SR) et qui comprennent typiquement une ou quelques centaines de paires identiques, et les câbles de transport, qui relient les sous-répartiteurs aux répartiteurs et qui peuvent comprend plusieurs centaines, voire plusieurs milliers de paires de cuivre torsadées identiques. Ces câbles sont des câbles de basse tension, leur tension de travail étant par exemple 42 V.

Tel qu'utilisé ici, le terme « paire de cuivre torsadée » ou « paire torsadée » s'applique à des brins conducteurs de tous types, et inclut en particulier tout brin en un métal autre que le cuivre (par exemple l'argent ou l'aluminium). Nous utilisons de manière générique le terme « paire de brins » pour englober tous les cas de conducteurs et de câbles.

Le terme « boucle locale » désigne la partie terminale du réseau pour laquelle il y a continuité métallique entre l'installation de l'usager et le commutateur le plus proche. Ce commutateur est typiquement un commutateur local (CL), mais peut aussi être un commutateur à autonomie d'acheminement (CAA).

Les câbles de distribution ou de transport de données peuvent avoir une masse linéaire considérable. À titre d'exemple, un câble de transport rassemblant 2 700 paires de cuivre torsadées avec un diamètre de brin de 0,4 mm représente une masse d'environ 7,3 kg au mètre linéaire.

### b) Description détaillée de l'invention

L'invention s'applique aux câbles électriques comportant au moins deux brins isolés, de préférence de diamètre identique. Pour pouvoir mettre en oeuvre le procédé selon l'invention il doit s'agir d'un câble inerte.

Selon l'invention, on détermine la capacité d'une paire de brins contenus dans le câble, i.e. contenus au sein du câble. La paire de brins sur laquelle la capacité est déterminée doit être inerte, i.e. elle ne doit pas être reliée à une source de tension. Cette détermination est faite à intervalles réguliers. La détermination de la capacité se fait sur une ou plusieurs paires de brins inertes qui forment un câble. La capacité déterminée exprime la longueur de la paire de brins. De manière typique, on ne surveille qu'une paire de brins par câble. Si le dispositif selon l'invention est configuré pour surveiller une pluralité de paires de brins, on préfère affecter cette possibilité de surveiller plusieurs paires de brins à la surveillance de plusieurs câbles plutôt qu'à la surveillance de plusieurs paires de brins du même câble.

De manière préférée, on sélectionne deux brins inertes formant une paire de brins. Les autres brins du câble n'ont pas besoin d'être inertes ; cela permet de surveiller un câble qui est en service (sauf pour la paire de brins qui a été débranchée et qui est utilisée pour le procédé selon l'invention).

Selon un mode de réalisation préféré de l'invention, lesdits deux brins de la paire de brins forment une paire de brins torsadées. De tels brins torsadés sont utilisées notamment dans des câbles de téléphonie ou des câbles de données (de type DSL ou ADSL par exemple), en tant que câbles de raccordement, câbles de distribution ou câbles de transport.

L'invention peut aussi être utilisé pour des câbles de transport de courant électrique inertes, en utilisant deux brins formant une paire.

L'invention peut être utilisée pour des câbles blindés ou non blindés. Plus précisément, on peut utiliser une paire de brins faisant partie d'un câble blindé, ou on peut mesurer la capacité entre un brin et le blindage.

L'invention peut être utilisée pour des câbles qui restent en place où ils avaient été installés initialement, par exemple sous terre et/ou dans un bâtiment ; pour exécuter le procédé selon l'invention il n'est pas nécessaire de les retirer de leurs fourreaux. L'invention peut aussi être utilisée pour des câbles qui ont été retirés de leurs fourreaux.

L'invention permet de surveiller la capacité d'une paire de brins. Toute variation brusque de cette capacité qui serait détectée est susceptible d'indiquer que le câble a été coupé. La détection d'un tel événement peut être utile, mais elle est souvent insuffisante car l'enjeu est de déterminer précisément la longueur découpée, notamment pour localiser l'endroit de la découpe sur le terrain. La capacité mesurée peut être transformée en unité de longueur en appliquant une constante de conversion. Cette constante de conversion peut être une valeur approximative, qui exprime l'expérience que la capacité d'une paire de brins de cuivre isolés est de l'ordre de 50 nF/km. La valeur précise dépend du type de câble, de son état d'usure, de l'environnement capacitif (notamment de l'humidité) et d'autres facteurs.

Si l'on souhaite documenter avec une plus grande précision la longueur du câble en unités de longueur, une calibration doit être effectuée au préalable pour chaque paire de brins surveillée. On détermine ainsi expérimentalement la constante de conversion pour une paire de brins donnée à laquelle elle va être appliquée par la suite. Cette calibration permet de transformer la capacité mesurée par le dispositif selon l'invention en une unité de longueur. Cette calibration est effectuée selon des méthodes connues de l'homme du métier, et de manière préférée à l'aide d'un échomètre.

On saisit la longueur initiale du câble. Cette saisie peut se faire sur une interface homme-machine prévue dans le dispositif selon l'invention, ou de manière préférée sur une machine informatique faisant partie du même réseau radioélectrique que le dispositif selon l'invention ; dans ce cas c'est ladite machine informatique qui envoie pour chaque canal de mesure (i.e., pour chaque carte fille) la valeur de calibration au dispositif.

Comme cela vient d'être mentionné, cette calibration n'est pas nécessaire dans le cas où l'on souhaite utiliser le dispositif selon l'invention simplement pour détecter la variation de la longueur du câble, en renonçant à la possibilité de déterminer avec précision la longueur de câble qui a été découpée. Ce mode d'utilisation du dispositif selon l'invention n'est probablement pas adapté à la plupart des besoins de ses utilisateurs, mais il peut être envisagé sans sortir du cadre de la présente invention.

Ensuite le dispositif mesure périodiquement un paramètre représentatif de la capacité électrique d'une paire de brins du câble. Tout changement significatif de la valeur de ce paramètre représentatif de la capacité indique un changement de la longueur du câble. Le dispositif selon l'invention permet donc de détecter le sectionnement d'un câble ; un tel événement peut indiquer qu'un vol de câble par découpe est en cours.

Le dispositif peut être configuré pour transmettre les mesures périodiques de longueur de câble vers une serveur de supervision via IP ; cette transmission peut se faire vis GSM ou toute autre voie sans fil. Une telle liaison sans fil, notamment de type IP/GSM, permet un déploiement sur un territoire vaste (national par exemple) et une supervision centralisée.

La transmission peut être chiffrée pour assurer une cybersécurité convenable. Les mesures effectuées par le dispositif peuvent être horodatées ; cela peut se faire par le dispositif lui-même ou par le serveur. Elles peuvent être historisées. Elles peuvent être retransmises vers un superviseur. Elles peuvent être affichées par le serveur, et/ou mises en forme et/ou ou traitées dans des tableaux.

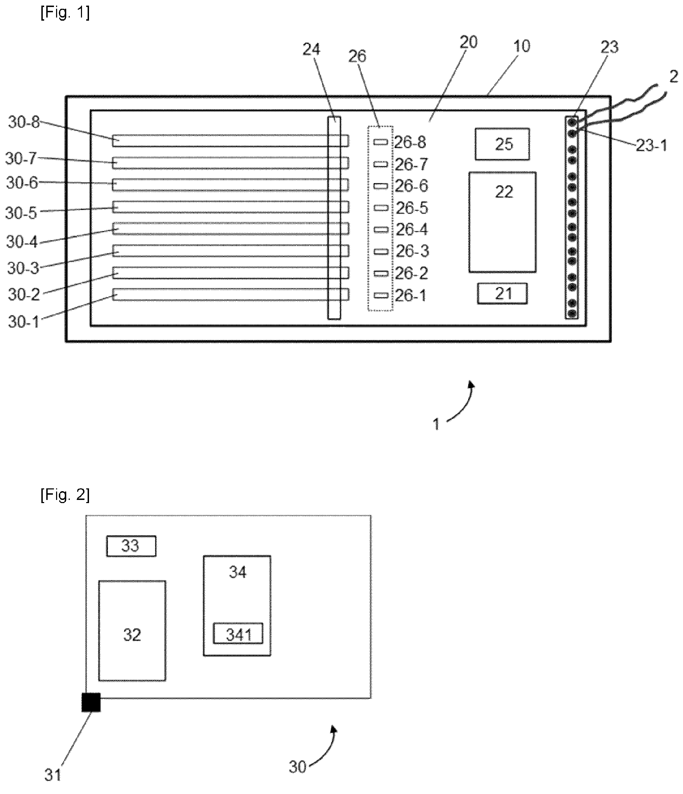

Nous décrivons maintenant le dispositif 1 selon l'invention, d'abord en relation avec la [Fig. 1]. Il se présente typiquement sous forme d'un boîtier 10 fermé par un couvercle, et présentant un premier bornier 23 dit bornier d'entrée avec au moins une paire de bornes 23-1 destinée à être connecté à la paire de brins du câble à surveiller. Typiquement (et comme montré sur la [Fig. 1], le dispositif est configuré pour permettre le branchement et la surveillance simultané d'une pluralité de paires de brins, par exemple huit paires. Les paires de brins formant cette pluralité de paires de brins peuvent appartenir au même câble ou à des câbles différents.

Le dispositif 1 comprend un carte mère 20 et au moins une carte fille 30, chaque carte fille étant configurée pour être connectée à une paire de brins à surveiller. Cette connexion se fait grâce au bornier d'entrée situé sur la carte mère 20. Typiquement, la carte mère 20 est disposée horizontalement, et les cartes filles 30 sont disposées verticalement par rapport à la carte mère 20 et parallèles les unes par rapport aux autres, comme cela est montré sur la [Fig. 1]. Typiquement, les cartes fille 30 s'enclenchent de manière verticale dans un deuxième bornier 24 dit bornier de cartes fille. Typiquement, ledit bornier 24 de carte fille se situe sur la carte mère 20, car cela assure une meilleure robustesse de la fixation de ce bornier sur la carte mère.

Le branchement de la paire de brins sur le bornier d'entrée 23 peut être un branchement direct ou un branchement indirect. Dans le cas d'un branchement indirect, les brins formant la paire de brin sont typiquement branchés sur le bornier d'entrée par l'intermédiaire de câbles de raccordement 2 (appelé en français parfois une « jarretière », mais l'homme du métier utilise plus couramment le terme « strap »). De manière typique, l'une des extrémités de chaque jarretière 2 est raccordée à un panneau de brassage où arrivent les brins du câble à surveiller ; il peut s'agir d'un répartiteur, qui peut être situé par exemple dans un central téléphonique, ou d'un sous-répartiteur.

Une carte fille 30 est représentée de manière schématique sur la [Fig. 2]. La carte fille comprend au moins une unité d'alimentation 33 capable d'alimenter les différents composants, l'unité de protection contre la foudre 32, une unité de mesure capacitive 34, un microcontrôleur 35, et au moins une unité d'interfaçage 36. Elle possède également un module de connexion 31 permettant sa connexion physique et fonctionnelle sur le bornier dit « bornier de cartes fille » situé sur la carte mère.

L'unité d'alimentation 33 est isolée. L'avantage de prévoir une unité d'alimentation 33 sur chacune des cartes fille est d'avoir ainsi une isolation galvanique et électrique de chacun des circuits de mesure des différentes cartes fille. Isoler chaque circuit de mesure permet de diminuer les potentielles interférences et donc augmenter la précision de la métrologie.

À partir du bornier d'entrée 23 se trouvant sur la carte mère, le circuit entre dans la carte fille 30 par l'intermédiaire du module de connexion 31. Sur la carte fille le circuit traverse d'abord un dispositif de protection contre la foudre 32 qui est monté sur la carte fille 30. Dans le cas où ce dispositif de protection contre la foudre s'avère être insuffisamment protecteur, il est préférable que ce soit la carte fille qui soit endommagée et non la carte mère, la carte fille étant moins coûteuse et plus facile à remplacer.

La carte fille possède un microcontrôleur 35. Ce microcontrôleur remplit quatre fonctions : l'acquisition des mesures de durée des cycles charge - décharge de la capacité représentée par la paire de brins du câble, le stockage de ces données, le filtrage de ces données, et la communication avec la carte mère. Ce microcontrôleur peut par exemple être de type STM32^{®}.

L'unité de mesure capacitive 34 se trouve en sortie du dispositif de protection contre la foudre. Elle comprend un circuit de mesure capacitive configuré pour charger une résistance et pour la décharger dans le brin. Plus la capacité est grande plus cette durée du cycle charge - décharge est longue. Le circuit de mesure capacitive comprend un microcontrôleur 341. Ce dernier comprend une horloge ; on enregistre le nombre de cycles d'horloge nécessaires pour accomplir un cycle de charge et décharge dans la paire de brins.

À titre d'exemple, l'horloge peut présenter une fréquence de 16 MHz. Pour un câble de transmission de données d'une longueur de 2000 m on mesure une capacité de l'ordre de 100 nF. Le temps d'acquisition est de l'ordre de 40 millisecondes (abrégé « ms »), ce qui permet d'acquérir environ 25 mesures par seconde sur la même paire de brins.

L'acquisition des données de durée est périodique, cette période étant typiquement comprise entre 1 ms et 100 ms. Un certain nombre de ces données successives sont stockées dans le microcontrôleur de la carte fille 35 de manière dynamique, chaque nouvelle donnée entrante efface la plus ancienne donnée encore en mémoire. Plus précisément, le nombre N de données successives stockées peut être compris par exemple entre environ 100 et environ 800, de préférence entre environ 250 et environ 650. Ces données sont filtrées numériquement, et on retient la valeur médiane. C'est cette valeur médiane de la durée (ou un autre paramètre caractéristique de la longueur du câble, tel que la capacité ou la longueur déterminée en tenant compte de la calibration) qui est renvoyée de la carte fille à la carte mère lorsque cette dernière adresse la requête à la première. Lors d'un changement brutal de la capacité du câble (par exemple en cas de coupe), il faut attendre qu'il y au moins la moitié de N données acquises pour retourner la valeur actuelle de la longueur du câble. À titre d'un premier exemple, avec N = 400, si pour un câble d'une longueur de 2000 m et d'une capacité d'environ 100nF (temps d'acquisition 40 ms), la capacité chute brusquement à 50 nF, le temps de mesure après la coupe passe à environ 20 ms, soit 50 mesures par seconde. La carte fille pourra alors envoyer à la carte mère une nouvelle donnée au bout de quatre secondes. À titre d'un deuxième exemple, également avec N = 400, pour un câble d'une longueur de 10 km et d'une capacité d'environ 500 nF (correspondant à 5 mesures par seconde), la nouvelle donnée correspondant à la longueur après coupure est renvoyée à la carte mère après 40 secondes.

Le procédé selon l'invention n'a pas besoin d'une granularité très fine car il compare un premier état stationnaire caractérisé par une première valeur de capacité (représentant une longueur qui est stable) à un deuxième état stationnaire caractérisé par une deuxième valeur ; sachant qu'en l'absence de modification de la longueur du câble, ces première et deuxième valeurs de capacité sont identiques.

La carte mère 20 comprend, entre autres, le bornier de cartes fille 24 qui a déjà été décrit, un processeur 22 qui sera décrit ci-dessous, une unité de relais 26 et une unité d'alimentation 21 capable d'alimenter les différents composants.

La communication entre une carte fille 24 et sa carte mère 20 peut se faire à l'aide d'une unité de communication 25 (bus) contrôlé par un processeur 22 tel qu'un ordinateur à carte unique (SBC, en anglais Single Board Computer). On peut utiliser par exemple un SBC de type Rasberry Pi^{®} ou équivalent. Ce processeur 22, situé sur la carte mère 20, envoie périodiquement une requête à chaque carte fille 30 pour obtenir l'envoi de la valeur médiane filtrée du paramètre caractéristique de la longueur du câble. Ce paramètre caractéristique de la longueur du câble peut être la longueur. Cela suppose que la conversion de la valeur de durée en valeur de longueur ait été effectué par le microprocesseur de la carte fille, en utilisant la calibration ; cette conversion de la valeur de durée en valeur de longueur peur transiter par une conversion de la valeur de durée en valeur de capacité. La périodicité de la requête peut se situer par exemple entre environ 1 seconde et environ 10 secondes, de préférence entre environ 2 secondes et environ 6 secondes. Une valeur de 3 secondes convient.

La carte mère 20 stocke (typiquement dans le processeur 22 décrit ci-dessus) les valeurs transmises par les cartes filles 30 pour pouvoir les leur renvoyer en cas de coupure de courant. La carte mère compare chaque valeur reçue d'une carte fille avec une valeur de seuil qui a été communiquée à la carte mère par la machine informatique distante du réseau radioélectrique selon l'invention. Dans le cas d'une différence jugée significative une alarme est déclenchée.

L'ordinateur à carte unique 22 exerce plusieurs fonctions.

Il gère les cartes fille 30, et en particulier la communication entre la carte mère et les cartes filles, il gère l'étalonnage du dispositif, il vérifie les seuils, et il gère le démarrage du dispositif.

Il peut également être configuré pour vérifier si le capot du dispositif est resté ouvert.

Il communique avec la machine informatique distante. Cette communication est bidirectionnelle.

En ce qui concerne la communication entre la carte mère et la machine informatique distante, la carte mère collecte les mesures de toutes les cartes fille et les transmet périodiquement (par exemple toutes les 30 secondes) à la machine informatique distante. Cette transmission peut se faire par exemple par une liaison 4G à partir de l'unité de communication 25. On peut utiliser un protocole de type MQTT. On peut utiliser un cryptage de type SSL/TLS.

De manière typique, pour chaque câble surveillé les informations suivantes sont communiquées périodiquement (par exemple toutes les 30 secondes) : l'identification du câble, la longueur actuelle du câble telle que déterminée par la mesure capacitive (typiquement exprimée en mètres), la constante de conversion de l'unité de capacité en unité de longueur (qui peut être une constante de calibration), la capacité (exprimée typiquement en nano-Farad ou en pico-Farad), la longueur avant la dernière découpe déterminée par échométrie, la valeur du seuil, et l'horodatage.

La carte mère peut être configurée pour générer une alerte en cas de franchissement de la valeur seuil d'une carte fille. Ce franchissement peut par exemple actionner un relais. L'unité de relais 26 située sur la carte mère comprend un relais 26-1,26-2,26-3,26-4,26-5,26-6,26-7,26-8 dédié à chaque carte fille 30-1,30-2,30-3,30-4,30-5,30-6,30-7,30-8. Chaque relais est configuré pour transmettre une alerte à la carte mère, qui la transmet de son tour (typiquement par un message de type MQTT (Message Queuing Telemetry Transport) à une machine informatique distante, pour générer une alerte qui est destinée par exemple à une équipe d'intervention.

Chaque relais peut être connecté à un équipement tiers, par exemple à une centrale d'alarme ou un automate programmable, pour rendre compte de l'état d'alarme de chaque câble surveillé par une carte fille. En parallèle, ces états d'alarmes sont transmis de manière sans-fil à un machine informatique distante, qui peut les faire suivre à d'autre système de surveillance centralisé (comme par exemple un logiciel de supervision / hypervision), les afficher sur une interface web ou encore les renvoyer par SMS aux différentes équipes d'intervention.

Ladite machine informatique distante peut être une machine informatique utilisateur, c'est-à-dire une machine informatique propre à un utilisateur qui est reliée à un ou plusieurs dispositifs selon l'invention, et/ou une machine informatique centrale relié à un ou plusieurs dispositifs selon l'invention et reliée à une ou plusieurs machines informatiques utilisateur, comme cela sera expliqué en plus grand détail ci-dessous.

Ainsi, non seulement chaque dispositif selon l'invention est totalement autonome par rapport aux autres faisant partie du même réseau radioélectrique selon l'invention, mais encore les informations découlant de la surveillance de chaque câble peuvent être traitées de manière totalement indépendante les unes des autres.

La structure du dispositif selon l'invention qui utilise une carte mère et une pluralité de cartes fille présente plusieurs avantages par rapport à d'autres architectures, telles que l'architecture mono-carte. En premier lieu, elle permet le remplacement aisé d'une carte fille défectueuse. Par ailleurs, elle facilite l'isolation électrique entre les cartes. Et enfin, elle conduit à un couplage inductif et capacitif plus faible entre les cartes. Avantageusement, l'architecture du dispositif est telle que la distance entre deux points de masse est supérieure à environ 10 mm, de préférence supérieure à environ 15 mm.

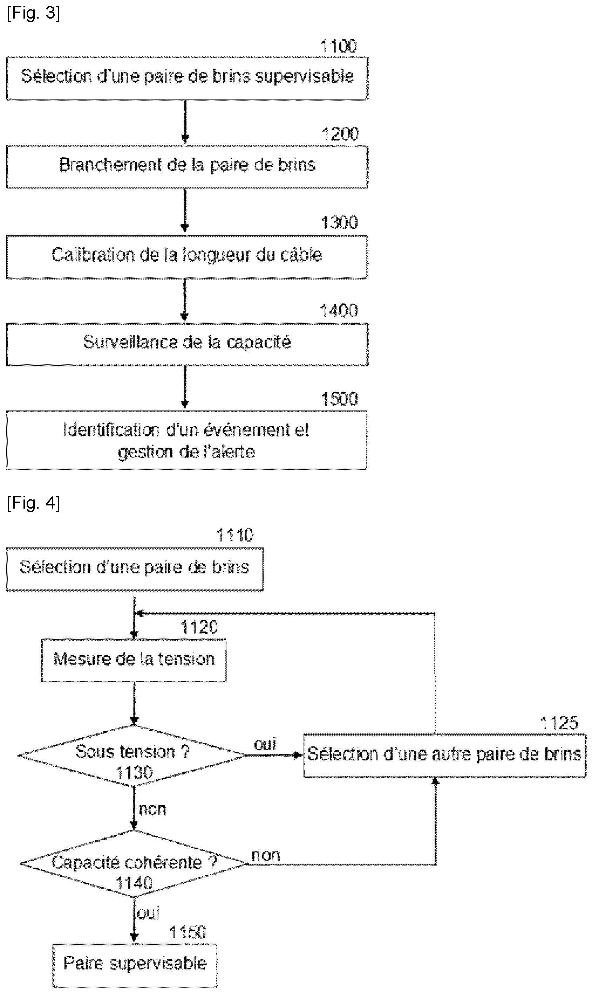

On décrit maintenant le procédé selon l'invention. Un procédé permettant d'exploiter le dispositif selon l'invention pour surveiller un câble inerte est représenté de manière schématique sur la [Fig. 3].

Dans une première étape 1100, qui est détaillée sur la [Fig.4], on sélectionne une paire de brins supervisables.

Dans une deuxième étape 1200 on branche la paire de brins supervisables sur le dispositif selon l'invention.

Dans une troisième étape 1300, qui est détaillée ci-dessous, on calibre le dispositif pour permettre d'exprimer le paramètre représentatif de la longueur du câble en unités de longueur. Cette étape est optionnelle, car on peut utiliser le dispositif et procédé selon l'invention pour surveiller un câble inerte sans connaître avec précision sa longueur.

Dans une quatrième étape 1400, on surveille la capacité du câble. Comme cela a été décrit ci-dessus en relation avec l'unité de mesure capacitive de la carte fille, on mesure périodiquement la capacité de la paire de brins à surveiller.

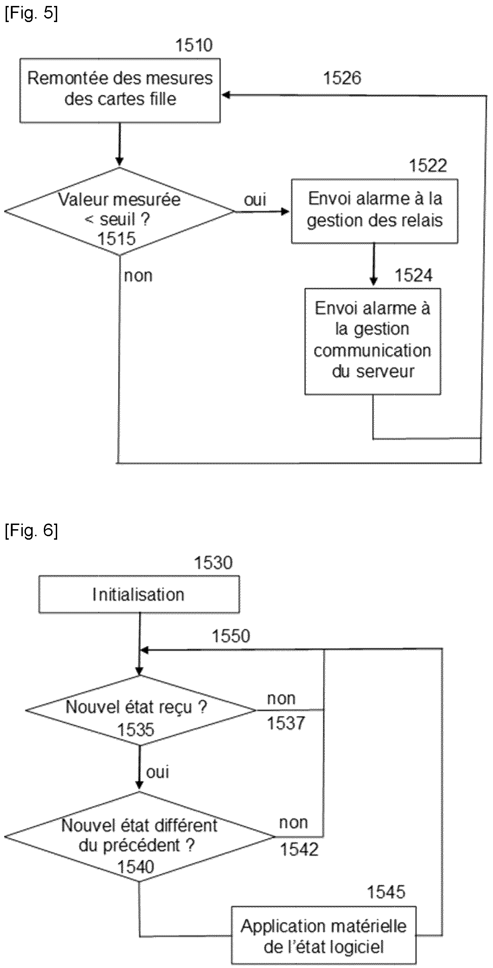

Dans une cinquième étape 1500, qui est détaillée sur la [Fig. 5], on détecte un événement de modification significative de la capacité du câble et on gère une alerte émise par le dispositif. Les mesures effectuées par chaque carte fille sont collectées, filtrées numériquement et gérées par la carte mère, qui assure également la gestion des relais et des alarmes. Lors de la détection d'un événement, un relais est activé sur la carte mère, et en parallèle une alerte est remontée par télétransmission au serveur client.

On décrit ici en plus grand détail un mode de réalisation de la première étape 1100, en relation avec la [Fig. 4]. Dans cette étape on sélectionne au moins une paire de brins inerte. Cette sélection comprend avantageusement un essai spécifique pour s'assurer que cette paire est inerte et supervisable.

Dans un mode de réalisation avantageux, cet essai spécifique comprend deux sous-étapes. On sélectionne 1110 une paire de brins. Dans une première sous-étape 1120 on vérifie si l'on détecte une tension aux bornes, à l'aide d'un voltmètre. Si l'on détecte une tension, cette paire n'est pas inerte, et on sélectionne 1125 une autre paire de brins, que l'on soumet au même essai 1120. Si l'on ne détecte pas de tension, on vérifie dans une deuxième sous-étape 1130 si la valeur de la capacité de la paire de brins est cohérente. Une incohérence de mesure peut se présenter par exemple si la paire de brins est endommagée, ou si le câble est immergé dans l'eau. De manière typique, le dispositif est configuré pour accepter comme « cohérente » une valeur de capacité comprise entre environ 30 nF/km et environ 70 nF/km. Cette vérification de la cohérence de la mesure de capacité suppose que l'on connaisse de manière approximative la longueur du câble (ce qui est normalement le cas), et que cette valeur ait été entrée et soit disponible pour le logiciel qui gère l'étape 1130 ; cette entrée de donnée ne figure pas sur le diagramme de la [Fig. 4]. Si on constate 1140 que cette valeur est cohérente, on considère 1150 que cette paire est supervisable. Dans le cas contraire on sélectionne 1025 une autre paire de brins.

On décrit ici en plus grand détail un mode de réalisation de la deuxième étape 1200. Dans cette étape, on branche cette paire de brin inerte jugée supervisable, directement ou indirectement, sur le bornier du dispositif. Le branchement direct ne nécessite pas de description spécifique ; nous décrivons ici le cas du branchement indirect à partir d'une baie de brassage. Pour cela, on établit dans une première sous-étape une liaison entre le bornier du dispositif et la tête du répartiteur, typiquement à l'aide d'un strap (le terme français « jarretière » étant peu usité dans ce contexte). Dans une deuxième sous-étape on établit une liaison entre les brins de la paire de brins à surveiller, ou, si cela est déjà fait, on vérifie si d'éventuels filtres et/ou dispositifs parafoudres se situant entre les brins à surveiller et la tête du répartiteur ont été déposés, contournés ou autrement neutralisés de manière à ne pas fausser la mesure de la capacité. L'ordre d'exécution de ces deux sous-étapes de la deuxième étape peut être inversé.

On décrit ici en plus grand détail un mode de réalisation de la troisième étape 1300. Dans cette troisième étape on détermine à l'aide d'un échomètre la longueur de chaque brin de la paire inerte à surveiller. Pour ce faire on branche la paire de brins à surveiller sur les deux bornes d'un échomètre (normalement à l'aide d'une jarretière) et on détermine la longueur de câble qui se déduit directement de la forme de la courbe d'écho affichée sur l'écran. Cette valeur de longueur est entrée par un utilisateur sur l'interface web du serveur central (à laquelle il accède par sa machine informatique utilisateur) qui transmet l'information par l'intermédiaire du réseau radioélectrique au dispositif concerné. Le dispositif concerné est configuré pour utiliser cette valeur de longueur pour déterminer une constante de calibration permettant de convertir la mesure de capacité en unité de longueur. Cette constante de calibration restera en mémoire dans le dispositif jusqu'à ce qu'elle soit remplacée par une nouvelle constante de calibration. Le dispositif communique cette constante de calibration à la machine informatique centrale pour contrôle et archivage.

Si l'utilisateur ne souhaite pas procéder à une calibration il peut entrer une valeur approximative de la longueur, ou même une valeur arbitraire ; cela n'empêche pas que le dispositif puisse surveiller le câble inerte et détecter un événement. C'est la localisation de cet événement sur la longueur du câble qui sera imprécise voire impossible si la longueur n'est pas convenablement calibrée au départ. Pour détecter qu'un câble stocké sur une aire de stockage à l'extérieur ou dans un hangar vient d'être coupé (et qu'il y a donc eu une intrusion) la simple détection de l'évènement peut suffire pour déclencher une alerte.

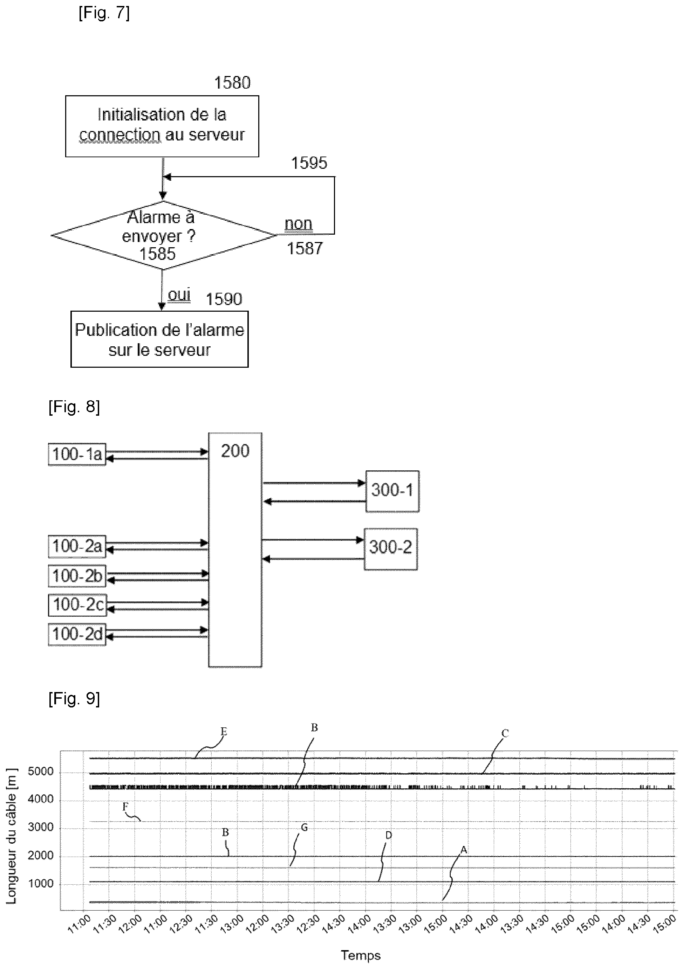

On décrit ici en plus grand détail un mode de réalisation de la cinquième étape 1500, en relation avec les [Fig. 5], [Fig. 6] et [Fig. 7] qui illustrent des procédés qui se déroulent dans le processeur de la carte mère. [Fig. 5] illustre la gestion des mesures, [Fig. 6] illustre la gestion des relais, [Fig. 7] illustre la gestion de la communication avec le serveur.

Dans cette cinquième étape on identifie un événement et on gère l'alerte. De manière périodique, les mesures sont remontées de chaque carte fille vers la carte mère (étape 1510). À l'étape 1515 chaque valeur est comparée à une valeur de seuil prédéterminée par l'utilisateur ; une valeur de défaut peut être prévue initialement. Cette étape 1515 peut être précédée par une ou plusieurs étapes de filtrage des données. En particulier, on peut prévoir qu'une valeur moyenne de deux ou plusieurs mesures successives est formée pour la rentrer dans l'étape 1515. On peut également prévoir que l'étape 1515 est parcourue un nombre de fois prédéterminé (par exemple deux ou trois fois), et qu'un événement (i.e., une comparaison conduisant à la réponse « Oui ») n'est retenu à l'étape 1515 que si chacune des comparaisons de ces valeurs en nombre prédéterminée conduirait à un événement. En l'absence d'événement, le procédé revient à l'étape 1526 vers l'étape initiale 1510.

En présence d'un événement, de manière avantageuse l'alerte est générée de deux manières indépendantes l'une de l'autre, à savoir : par l'envoi câblé d'une alarme sur un relais 26 (étape 1522) et par l'envoi, par une liaison sans fil, d'une alarme à la fonction gestion de la communication avec le serveur (étape 1524). Les étapes 1522 et 1524 peuvent être inversées, mais cela n'est pas préféré. Cette redondance de communication assure que la défaillance de l'un des deux systèmes n'a pas d'impact sur le fonctionnement de l'autre. Le procédé revient ensuite à l'étape 1526 vers la configuration initiale 1510 lui permettant de recevoir de nouveau des données de la carte fille correspondant au cycle de mesures suivant.

[Fig. 6] illustre le procédé qui se déroule à l'issue de l'étape 1522, de manière parallèle. À l'étape 1530 l'interface de gestion des relais est initialisé. À l'étape 1535 une requête est lancée pour s'enquérir de la réception d'un nouvel état. Dans l'affirmative, ce nouvel état est comparé à l'ancien état à l'étape 1540. S'il est différent, à l'étape 1545 ce nouvel état est transcrit en configuration matérielle au niveau du relais affecté à la carte fille dont provient le signal d'alerte. Si aucun état nouveau n'a été reçu (étape 1537), ou si le nouvel état est identique à l'état précédent (étape 1542), le procédé retourne à l'état 1550 vers la requête 1535.

[Fig. 7] illustre le procédé qui se déroule à l'issue de l'étape 1524, de manière parallèle. À l'étape 1580 l'interface de gestion de la connexion au serveur est initialisé. À l'étape 1585 une requête est lancée pour s'enquérir de la réception d'une alarme. Dans l'affirmative, cette alarme est publiée sur le serveur à l'étape 1590. On entend ici par « publication » toute mise à disposition de l'alarme pour un utilisateur, par tout moyen approprié. Si aucune alarme n'a été reçue à l'étape 1587 le procédé retourne à l'étape 1595 vers la procédure de réinitialisation de l'étape1580.

On décrit maintenant le réseau radioélectrique selon l'invention qui permet d'utiliser de manière avantageuse le dispositif selon l'invention et de mettre en œuvre le procédé selon l'invention. [Fig. 8] montre un mode de réalisation d'un réseau radioélectrique selon l'invention. Il comprend au moins une machine informatique centrale 200, une pluralité de dispositifs selon l'invention 100 et une pluralité de machines informatiques utilisateur 300.

La machine informatique centrale 200 est en liaison bidirectionnelle avec une pluralité de dispositifs selon l'invention 100-1a, 100-2a, 1 00-2b, 100-2c, 100-2d. Cette liaison est typiquement une liaison par internet. Chacun de ces dispositifs est configuré pour surveiller au moins une paire de brins, et de préférence une pluralité de paires de brins. Par ailleurs, la machine informatique centrale 200 est en liaison bidirectionnelle avec une pluralité de machines informatique utilisateurs 300-1, 300-2. Cette liaison est typiquement une liaison par internet.

Dans l'exemple de la [Fig. 8], le dispositif 100-1a appartient à l'utilisateur de la machine informatique utilisateur 300-1, et les dispositifs 100-2a, 100-2b, 100-2c et 100-2d appartiennent à l'utilisateur de la machine informatique utilisateur 300-2.

La machine informatique centrale 200 gère une pluralité de dispositifs 100 ; elle agit comme un serveur. Ce serveur permet de collecter les données des différents dispositifs selon l'invention. Il héberge une interface client pour paramétrer, maintenir et exploiter les dispositifs.

Chaque nouveau dispositif 100 doit être enregistré sur ce serveur. Pour ce faire, on se connecte à une interface spécifique l'interface du serveur, on ouvre une page spécifique qui permet l'enregistrement d'un nouveau dispositif, on dépose un fichier contenant des paramètres d'identification du dispositif ainsi que sa clé publique. Le serveur est configuré pour créer l'objet du nouveau dispositif ainsi que les objets des câbles associés (i.e., surveillés) par ce dispositif.

La machine informatique centrale 200 peut être configurée de manière à agir comme une interface centralisée de paramétrage, de maintenance, de suivis de chantier, de visualisation d'alertes. Elle peut aussi agir comme un intermédiaire unique à d'autres systèmes informatiques de surveillance, tels qu'un système de télésurveillance utilisateur, un superviseur, un hyperviseur.

La machine informatique utilisateur 300 exploite typiquement une interface web en liaison avec la machine informatique centrale 200. La machine informatique utilisateur permet à l'utilisateur de paramétrer les dispositifs qui sont associés à cet utilisateur. En particulier, elle permet d'effectuer la vérification de la cohérence de la capacité 1140 lors de la sélection d'une paire de brins supervisables 1100. Elle permet également d'entrer la longueur du câble qui a été déterminée par l'utilisateur (typiquement par échométrie) ou qui est une valeur estimée ou approximative, dans le cas où une grande précision de la valeur de la longueur du câble n'est pas requise. La machine informatique utilisateur permet également à l'utilisateur de définir le seuil d'alerte de chaque relais. Elle permet également à l'utilisateur de visualiser les données et les alertes, de créer des sous-groupes de dispositifs pour des utilisateurs internes spécifiques, et d'exporter ces données sous un format approprié.

Dans une variante (non représentée sur les figures) de ce réseau radioélectrique selon l'invention, ledit réseau comprend encore, en lieu et place d'une ou plusieurs des machines informatiques utilisateur 300, d'autres serveurs tel qu'un hyperviseur.

L'invention peut avoir plusieurs utilisations différentes. Elle peut servir à surveiller des chantiers de dépose de câble. Dans cette situation elle permet de détecter un vol de câble. Plus précisément, elle permet de détecter, en temps réel (c'est-à-dire avec un temps de réponse de quelques secondes ou dizaines de secondes) la diminution de la capacité du câble, cette capacité exprimant la longueur du câble. Comme indiqué ci-dessus, pour être capable de déterminer avec précision la longueur du câble découpé, il faut avoir effectué au préalable une calibration, typiquement à l'aide d'un échomètre.

Selon l'invention, le dispositif ou le réseau radioélectrique dans lequel il est intégré est configuré pour générer une alerte en cas d'un événement de diminution brusque de capacité du câble. Ainsi un superviseur connaissant la localisation du dispositif selon l'invention qui effectue la mesure du paramètre représentatif de la capacité, et disposant d'un plan de cheminement du câble peut indiquer aux équipes d'interception où l'événement (qui est susceptible de correspondre à un vol à la découpe) est en train de se dérouler.

L'invention permet également de vérifier si la longueur de câble découpée par un intervenant autorisé correspond à la longueur de câble pour la découpe de laquelle il a été autorisée, et/ou correspond à la longueur de câble qu'il déclare avoir prélevée (par exemple lors de son dépôt au centre de recyclage).

Lorsqu'une longueur du câble à surveiller a été découpée, la valeur résiduelle du câble peut devenir la nouvelle valeur seuil pour la poursuite de la surveillance. Cette détermination de la valeur résiduelle et son entrée en tant que nouvelle valeur seuil peut être faite par l'utilisateur sur l'interface informatique utilisateur, ou elle peut être faite de manière automatique par la machine informatique utilisateur.

Le dispositif et le procédé selon l'invention présentent de nombreux avantages par rapport à une mesure à l'aide d'un échomètre. Le dispositif selon l'invention est plus simple qu'un échomètre. Il est bien moins coûteux qu'un échomètre, même en tenant compte du besoin de disposer d'un échomètre pour réaliser l'étalonnage initial du dispositif selon l'invention. Ce coût nettement inférieur permet d'envisager un déploiement massif de dispositifs selon l'invention, par exemple sur une aire de stockage de câbles neuf ou destinés au recyclage.

Le dispositif et le procédé selon l'invention offrent une fonction qui n'était pas assurée jusqu'à maintenant, à savoir la surveillance permanente de la longueur d'un câble inerte.

Il permet la surveillance de câbles inactifs, et permet plus particulièrement de détecter des événements liés au découpage du câble. Il permet notamment de détecter le découpage du câble et de localise l'emplacement de la découpe sur le câble. On peut ajouter une fonction d'horodatage de l'événement.

Cette fonction de surveillance est assurée de manière discrète : d'une manière générale, dans le cadre de la présente invention il est impossible de détecter de l'extérieur qu'un câble inerte est sous surveillance. Le dispositif se présente sous la forme d'un petit boîtier qui peut être installé discrètement, typiquement dans un local sécurisé, qui peut être un local technique de type central téléphonique. Si le dispositif est installé sur une aire de stockage, il est souvent possible de le poser dans un coffret ou une borne déjà existante. N'ayant pas d'opérations à accomplir à l'extrémité du câble, le sous-traitant de dépose ou le voleur ne sais pas que le câble est sous surveillance et pourra être intercepté en flagrant délit.

La méthode selon l'invention, basée sur une mesure de capacité, évite d'avoir à intervenir sur les deux extrémités du câble à la fois, contrairement à une mesure résistive qui nécessite une mise en court-circuit ou la connexion d'une résistance de bouclage.

### Exemples

### Exemple 1 : Stabilité du dispositif

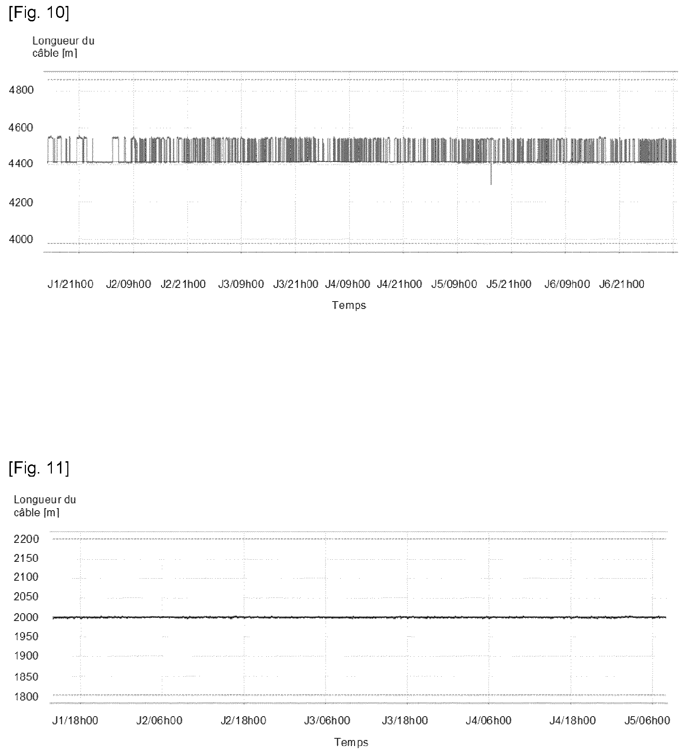

On a utilisé un dispositif selon l'invention comportant une carte mère et huit cartes filles, qui était capable de surveiller huit câbles de manière indépendante (repérés de A à H). On a branché chaque carte fille à une paire de brins d'un câble différent. Il s'agissait de câbles de transport ou de distribution de données, qui était inertes, mais qui se trouvaient toujours dans les gaines dans lesquelles ils avaient été posés lors qu'ils étaient encore en service, reliant au panneau de brassage d'un répartiteur situé dans un bâtiment à des sous-répartiteurs situés dans des boîtiers au bord d'une route. Leur longueur était différente. On a calibré chaque carté fille en introduisant la valeur de la longueur du câble déterminée à l'aide d'un échomètre. On a ensuite enregistré l'évolution de la capacité sur plusieurs jours. Le résultat est montré sur les [Fig. 9], [Fig. 10] et [Fig. 11]. Sur ces figures, l'axe horizontal représente le temps et l'axe vertical la longueur du câble, telle que déterminée à partir de la mesure de la capacité et de la calibration effectuée avec l'échomètre.

[Fig. 9] montre l'évolution de la longueur au cours du temps, pendant quatre heures. On voit que cette longueur n'évolue pas, ce qui est normal, car le câble n'a pas été sectionné pendant le temps de suivi. On voit également que les fluctuations du signal sont très faibles. [Fig. 10] montre un agrandissement de l'axe vertical pour le câble B qui montrait le plus de fluctuation (surveillé pendant cinq jours), et [Fig. 11] montre un agrandissement de l'axe vertical pour le câble qui montrait la fluctuation la plus faible. On remarque que le câble montré sur la [Fig. 10] est un cas atypique parmi les huit câbles surveillés.

D'une manière générale, la fluctuation est inférieure à 3%, et pour les câbles les plus stables (comme celui de la [Fig. 11]) inférieure à 0,25 %. Cette remarquable stabilité permet de fixer un seuil d'alerte tel que la découpe d'une trentaine de mètres de câble par kilomètre peut être détectée, sans risque de faux positifs.

La valeur absolue de la capacité mesurée est de l'ordre de 0,047 nF par mètre de câble de calibre 4.

### Exemple 2 : Détection du sectionnement du câble

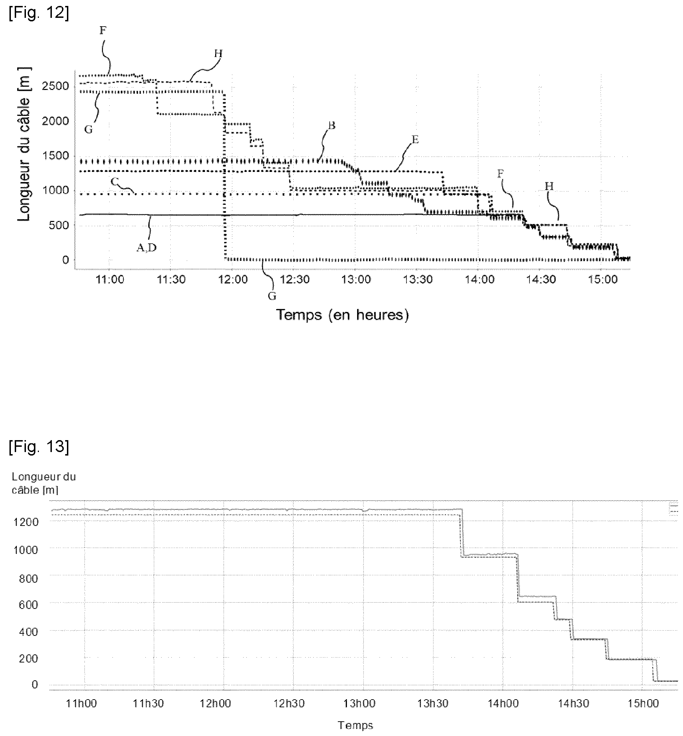

Le dispositif de l'exemple 1, branché sur les mêmes câbles, a été utilisé par la suite pour détecter le sectionnement des câbles. Les résultats sont montrés sur [Fig. 12] et [Fig. 13], qui sont du même type que les [Fig. 9] à [Fig. 11]. [Fig. 12] montre la surveillance des huit câbles, avec des découpes de longueurs différentes réalisées à des moments différents. Les mesures sont horodatées. [Fig. 13] montre le détail du suivi du câble E de la [Fig. 12]. La courbe supérieure correspond à la longueur du câble déterminée par le dispositif selon l'invention, la courbe inférieure (pointillée) correspond à la longueur du câble déterminée par échométrie. L'erreur relative moyenne ne dépasse pas 3,5 %.

## Revendications

1. Dispositif (1,100) pour surveiller pendant une certaine durée de surveillance un câble inerte, notamment pour détecter un événement se produisant au cours de cette durée de surveillance, tel que sa découpe, ledit dispositif étant configuré pour déterminer de manière répétée la valeur d'un paramètre représentatif de la longueur d'une paire de brins sélectionnée au sein dudit câble, et pour détecter un événement de diminution brusque de cette valeur,
ledit dispositif étant **caractérisé en ce qu'**il comprend une carte mère (20) et une pluralité de cartes fille (30),
chaque carte fille étant configurée pour déterminer sur une paire de brins inerte un paramètre représentatif de la longueur de ladite paire de brins, et pour transmettre ce paramètre ce paramètre à la carte mère,
et la carte mère étant configurée pour comparer, pour chaque carte fille, les paramètres représentatifs de la longueur à une valeur de seuil, et pour déclencher une alerte en cas de franchissement de cette valeur de seuil.

2. Dispositif selon la revendication 1, **caractérisé en ce que** ledit paramètre représentatif de la longueur d'une paire de brins est déterminé à partir d'une mesure capacitive, un circuit de mesure capacitive se trouvant de préférence sur chaque carte fille (30).

3. Dispositif selon l'une quelconque des revendications 1 ou 2, **caractérisé en ce que** ladite carte mère (20) comprend une unité de relais (26), permettant d'actionner pour chaque carte fille (30) un relais en cas de franchissement du seuil.

4. Dispositif selon l'une quelconque des revendications 1 à 3, **caractérisé en ce que** chaque carte fille comporte une unité d'alimentation (30) et une unité de protection contre la foudre (32).

5. Dispositif selon l'une quelconque des revendications 2 à 4, **caractérisé en ce que** la carte fille (30) comprend un microcontrôleur (341) configuré pour acquérir des mesures de durée de cycles charge - décharge de la capacité représentée par la paire de brins de câble, pour stocker ces données, éventuellement pour effectuer un filtrage numérique de ces données, et pour les communiquer à la carte mère.

6. Procédé pour surveiller pendant une certaine durée de surveillance un câble inerte, notamment pour détecter un événement se produisant au cours de cette durée de surveillance, tel que sa découpe, ledit procédé comprenant :
- la sélection d'une paire de brins supervisables,
- le branchement de ladite paire de brins sur un dispositif capable déterminer la capacité initiale de ladite paire de brins,
- la mesure répétée au cours de ladite durée de surveillance d'un paramètre représentatif de la longueur de ladite paire de brins issu de la détermination de la capacité initiale de ladite paire de brins,
- la surveillance dudit paramètre représentatif de la longueur par ledit dispositif.

7. Procédé selon la revendication 5, dans lequel on effectue une calibration dudit paramètre représentatif de la longueur pour exprimer une unité de longueur, ladite calibration étant de préférence établie à l'aide d'un échomètre.

8. Procédé selon l'une quelconque des revendications 6 à 7, dans lequel on déclenche une alerte lorsque ledit paramètre représentatif de la longueur franchit un certain seuil indiquant une coupure dudit câble.

9. Procédé selon l'une quelconque des revendications 6 à 8, dans lequel ladite paire de brins fait partie d'un câble de transmission de données installé sur un commutateur, le branchement entre lesdits brins et ledit dispositif se faisant par l'intermédiaire d'une jarretière, dont une extrémité est connectée audit dispositif, directement ou par l'intermédiaire d'une tête de répartiteur.

10. Procédé selon l'une quelconque des revendications 5 à 9, dans lequel, lorsque ledit paramètre représentatif de la longueur change d'une première valeur vers une deuxième valeur et indique qu'une certaine longueur de câble a été découpée, on utilise cette deuxième valeur comme la nouvelle valeur initiale, et on poursuit le procédé pour surveiller ledit câble inerte.

11. Utilisation d'un dispositif selon l'une quelconque des revendications 1 à 5 pour la surveillance de câbles inertes, lesdites câbles étant des câbles pourvus de paires de brins torsadés, et notamment de câbles de transmission de données, lesdits câbles inertes pouvant notamment être des câbles installés laisses en place en attente de leur démantèlement, ou des câbles en attente sur un lieu d'entreposage, notamment en attente de leur installation ou de leur recyclage.

12. Réseau radioélectrique pour la surveillance de la longueur d'une pluralité de câbles inertes, comprenant :
- une pluralité de dispositifs (100) selon l'une quelconque des revendication 1 à 5,
- une machine informatique centrale (200) configurée pour communiquer de manière bidirectionnelle avec lesdits dispositifs (100), de préférence par l'intermédiaire de leur carte mère (20), pour centraliser les mesures reçues par ladite pluralité de dispositifs, pour pourvoir transmettre des données à une machine informatique utilisateur, pour rerouter les alertes générées par un dispositif vers une machine informatique utilisateur et/ou une installation de surveillance utilisateur, et pour pouvoir calibrer et maintenir les dispositifs,
- et au moins une machine informatique utilisateur (300) configurée pour communiquer de manière bidirectionnelle avec ladite machine informatique centrale (200), pour, en particulier, effectuer la vérification de la cohérence de la mesure de capacité lors de la sélection de la paire de brins, pour entrer la longueur de câble déterminée par la calibration, pour entrer la valeur de seuil, et pour exporter de données générées par ledit dispositif et/ou ladite machine informatique centrale.

13. Réseau radioélectrique selon la revendication 12, **caractérisé en ce que** ladite machine informatique centrale (200) est configurée pour mettre à la disposition d'un utilisateur, par l'intermédiaire de la machine informatique utilisateur (300), une interface utilisateur personnelle permettant à l'utilisateur d'effectuer la vérification de la cohérence de la mesure de capacité lors de la sélection de la paire de brins, d'entrer la longueur de câble déterminée par la calibration, d'entrer la valeur de seuil, et d'exporter des données générées par ledit dispositif et/ou ladite machine informatique centrale.

14. Réseau radioélectrique selon la revendication 12 ou 13, **caractérisé en ce que** ladite machine informatique utilisateur (300) est configurée pour que, dans le cas où ledit paramètre représentatif de la longueur change d'une première valeur vers une deuxième valeur et indique qu'une certaine longueur de câble a été découpée, cette deuxième valeur soit utilisée comme la nouvelle valeur initiale, et on poursuit le procédé pour surveiller ledit câble inerte.
